# EUROPÄISCHE PATENTANMELDUNG

(11) **EP 2 610 372 A2**
(43) Veröffentlichungstag der Anmeldung: **03.07.2013**
(21) Anmeldenummer: 12008516.2
(22) Anmeldetag: 21.12.2012
(51) Int. Cl.: C30B 29/06, C30B 33/02

(54) **Verfahren zur Oberflächenpräparation von Si(100)-Substraten**

(30) Priorität: 30.12.2011 DE 102011122749
(71) Anmelder: Helmholtz-Zentrum Berlin für Materialien und Energie GmbH, 14109 Berlin (DE)
(72) Erfinder: Brückner, Sebastian, 10997 Berlin (DE); Döscher, Henning, 10829 Berlin (DE); Hannappel, Thomas, 10779 Berlin (DE); Kleinschmidt, Peter, 99089 Erfurt (DE); Dobrich, Anja, 12305 Berlin (DE); Supplie, Olivier, 12055 Berlin (DE)

(57) **Zusammenfassung**

Bekannte Verfahren zur Beeinflussung der Domänenausbildung mit Typ-A-Terrassen zwischen D_{A}-Doppelstufen und Typ-B-Terrassen zwischen D_{B}-Doppelstufen bei der Oberflächenrekonstruktion einer Si(100)-Schicht auf einem unkontaminierten, glatten Si(100)-Substrat mit bekannter Fehlorientierung beziehen sich auf Oberflächenpräparationen im Ultrahochvakuum unter Anwendung äußerer elektrischer oder mechanischer Kräfte oder Ionenbombardements. Das erfindungsgemäße Verfahren ermöglicht ohne Anwendung äußerer Kräfte oder Ionen eine in ihrem Anteil wählbare Herstellung von Doppelstufen auf Si(100)-Oberflächen innerhalb einer druckbeaufschlagten CVD- bzw. MOVPE-Umgebung für verschiedene Fehlorientierungen des Siliziumsubstrats, wobei auch bislang in der Fachwelt als unwahrscheinlich erachtete D_{A}-Doppelstufen, einstellbar erzeugt werden können. Der Rekonstruktionsprozess ist durch gezielte Anwendung von Prozessparametern undzyklen reversibel zwischen den einzelnen Terrassentypen steuerbar, wobei zur Auswahl der Prozessparameter in Abhängigkeit von der angestrebten Oberflächenrekonstruktion Präparationsdiagramme A, B, C in Abhängigkeit von der Fehlorientierung angegeben werden. Die erzeugten, in ihrer Domänenorientierung einstellbaren Si-Schichtsysteme können beispielsweise in der Mikro-und Opto-Elektronik und in der Hocheffizienzphotovoltaik eingesetzt werden.

## Beschreibung

Die Erfindung bezieht sich auf ein Verfahren, das der Oberflächenpräparation von kontaminationsfreien und glatten Si(100)-Substraten mit bekannter Fehlorientierung in Wasserstoffumgebung bei einem Prozessdruck dient, mit einer Beeinflussbarkeit der Ausbildung von Terrassen vom Typ A mit einem Vorzug für D_{A}-Doppelstufen mit senkrecht zu den Stufenkanten angeordneten Si-Dimeren oder Typ B mit einem Vorzug für D_{B}-Doppelstufen mit parallel zu den Stufenkanten angeordneten Si-Dimeren während der Oberflächenpräparation der wasserstoffterminierten Si(100)-Oberfläche zumindest durch Verringerung der Prozesstemperatur T.

Oberflächenrekonstruktionsdomänen (kurz Domänen, "Gebiete") definieren sich über die Ausrichtung der Dimere innerhalb der Domäne. Abhängig vom Stufentyp kommt es zur Ausbildung von Vorzugsdomänen (Single Domains mit Terrassen zwischen Doppelstufen), wenn bevorzugt Doppelstufen eines Typs präsent sind, also nur ein Terrassentyp auftritt. Bei Si-Oberflächen mit Einzelstufen sind beide Terrassentypen anwesend, also eine Mischung beider Domänen. In der Regel werden Si(100)-Substratoberflächen mit einer einzigen Domäne bevorzugt, weil es beim Wachstum von III-V-Halbleiterschichten auf Si(100)-Substraten mit gemischten Domänen zur Bildung von Defekten in der kristallinen Struktur der epitaktisch abgeschiedenen Schicht, so genannte Antiphasendomänen (APD). Die Konzentration dieser Defekte kann die technologisch angestrebte Nutzung solcher Schichtsysteme bzw. Materialkombinationen in der Mikro- und Opto-Elektronik und in der Hocheffizienzphotovoltaik (z.B. für hocheffiziente Solarzellen, Laser, LEDs) entscheidend beeinflussen oder sogar verhindern. Für andere Anwendungen können APDs und damit eine kontrollierte Durchmischung von unterschiedlich orientierten Domänen ggfs. erwünscht sein. Ziel ist daher eine einstellbare Ausprägung der Oberflächenrekonstruktionsdomänen. Spezielle Messverfahren ermöglichen mittlerweile eine in-situ-Kontrolle der sich beim Wachstumsprozess ausbildenden Oberflächenrekonstruktionsdomänen (optische in-situ Charakterisierung des APD-Gehaltes).

Silizium kristallisiert in der Diamantstruktur, in der jedes Si-Atom in tetraedrischer Koordination von vier weiteren Si-Atomen umgeben ist. Ausgehend von der Diamantstruktur besitzt die Oberfläche ein quadratisches Grundgitter. Bei einer unrekonstruierten Oberfläche (keine Dimerbildung) würde an allen Eckpositionen und in der Flächenmitte ein Atom sitzen. Auf einer solchen Oberfläche hätte jedes Atom zwei halbgefüllte sp3- Hybridorbitale, die auch als "dangling bonds" bezeichnet werden. Dieser sehr energiereiche Zustand der Oberfläche wird durch eine Bindung von jeweils zwei Atomen zu einem Dimer vermieden (rekonstruierte Oberfläche). Die Bindung erfordert eine Annäherung von zwei Si-Atomen der ersten Lage aus ihrer Gleichgewichtsposition heraus. Dies führt zu einer Verspannung der Kristallstruktur, die sich bis in die fünfte Atomlage erstreckt. Der Energiegewinn durch die Reduzierung der freien dangling bonds ist jedoch größer als der Energieverlust durch die elastische Verspannung des Kristalls. Die Silizium-Dimere ordnen sich entlang von Reihen an. Aufgrund der tetraedrischen Kristallstruktur ändert sich die Orientierung der Bindungen von Lage zu Lage, sodass an einer monoatomaren Stufe auch die Dimerreihen ihre Orientierung um 90° drehen.

Die atomare Struktur von monoatomaren Stufen und Doppelstufen wurde erstmals durch STM-Untersuchungen (Raster-Tunnel-Mikroskopie) ermittelt. Später gelang es, die Beobachtungen theoretisch nachzuvollziehen und Voraussagen über das Auftreten von Doppelstufen zu machen. Doppelstufen entstehen durch das Zusammentreffen von zwei Einfachstufen und verlaufen im Si-System zweifach aufsteigend bzw. absteigend. Die Präparation solcher Doppelstufen erlaubt die grundlegende Vermeidung von Antiphasenunordnung bei der Epitaxie von polaren Materialien auf nicht-polarem Si(100).

Die Form der monoatomaren Stufen wird mit S_{A} und S_{B} bezeichnet, wobei sich bei einer S_{A}-Stufe die einzelnen Si-Dimere der oberen Terrasse senkrecht zur Stufenkante und bei einer S_{B}-Stufe parallel dazu anordnen. Dabei begrenzen die Stufen einzelne Terrassen. Zwischen Einzelstufen ändert sich die Orientierung der Si-Dimere, sodass die Domänen auf die einzelnen Terrassen beschränkt sind. Zwischen Doppelstufen ändert sich die Orientierung der Dimere nicht, sodass die Domänen mehrere Terrassen gleicher Orientierung übergreifen. Eine Typ-A-Terrasse erstreckt sich zwischen D_{A}-Doppelstufen, eine Typ-B-Terrasse erstreckt sich zwischen D_{B}-Doppelstufen. Eine regelmäßige Stufenabfolge, bei der die Terrassen abwechselnd von Einfachstufen des Typs S_{A} und S_{B} begrenzt sind, wird aus energetischen Gründen insbesondere bei relativ geringer Fehlorientierung des Siliziumsubstrats (unter 4°) ausgebildet. Unter der "Fehlorientierung" wird die Winkelabweichung der Substratschnittebene zur Kristallebene verstanden. Die Fehlorientierung des Substrats ist ein wesentlicher Parameter bei der Stufenausprägung. Die reinen Stufentypen treten nur auf, wenn die Fehlneigung genau in einer Hauptsymmetrierichtung verläuft, anderenfalls bestehen die Stufen aus Mischungen der beiden Typen. Bei einer Ausgangsfläche mit einer Fehlneigung von etwa 0, 3° verlaufen nur die S_{A}-Stufen glatt, während die S_{B}-Stufen stark "ausgefranst" aussehen. Diese Beobachtung kann durch die unterschiedlichen Energien pro Atom einer Stufe erklärt werden. Auf breiten Terrassen kann aufgrund von Entropieeffekten der Stufenverlauf fluktuieren. Die Stufenbildung ist ein dynamischer, reversibler Prozess. In Abhängigkeit von der Stufenbreite treten Wechselwirkungen innerhalb von Stufen auf, die zu einer Ausbildung von Doppelstufen aus einer Kombination von einer S_{A}-und einer S_{B}-Stufe führen. Bei D_{B}-Stufen verlaufen die Si-Dimerreihen auf der oberen und unteren Terrasse senkrecht zur Stufe (Typ-B-Terrasse, Kombination S_{A}+S_{B}), die einzelnen Si-Dimere stehen parallel zur Stufenkante. Bei D_{A}-Stufen verlaufen die Si-Dimerreihen auf der oberen und unteren Terrasse parallel zur Stufe (Typ-A-Terrasse; Kombination S_{B}+S_{A}), die einzelnen Si-Dimere stehen senkrecht zur Stufenkante. D_{A}-Stufen sind unüblich, wohingegen D_{B}-Stufen aus energetischen Gründen als bevorzugt gelten.

### Stand der Technik

Die Stufenstruktur von Si[100] ist bezüglich der Theorie für die reine Oberfläche in der Veröffentlichung I "Stabilities of Single-Layer and Bilayer-Steps on Si(001) Surfaces" (von D.J. Chadi in Phys. Rev. Lett., Vol. 59 (1987), No. 15, pp. 1691-1694) und bezüglich der experimentellen Überprüfung für die reine und die wasserstoffterminierte Oberfläche im UHV (Ultra High Vacuum) in der Veröffentlichung **II** "Step structure and surface morphology of hydrogen-terminated silicon: (01) to (114) (von A.R. Laracuente et al. in Surface Science 545 (2003) 70-84) beschrieben.

Bisher können Si(100)-D_{B}-Doppelstufen üblicherweise nur im UHV und auf stark fehlorientierten Substraten zuverlässig erzeugt werden. Im UHV kann die Stufenstruktur durch Elektromigration durch das Anlegen starker, gerichteter, makroskopischer Kräfte wie Gleichstrom (vergleiche Veröffentlichung **III** "Anisotropic diffusion between the step-up and the step-down directions on a Si(001) surface" von T. Doi in Phys. Rev. B, Vol. 53 (1996), No. 24, pp. 16609-16614) oder mechanische Verspannung (vergleiche Veröffentlichung **IV** "Si(100) Surface under Externally Applied Stress" von F.K.Men at al. in Phys. Rev. Lett., Vol 61 (1988), No. 21, pp. 2469-2471) gezielt beeinflusst werden, sodass auch unübliche D_{A}-Stufen erzeugt werden können. Die Ausbildung von D_{A}-Stufen durch Edelgas-Ionenbombardements wird in der Veröffentlichung **V** "Anisotropic Vacancy Kinetics and Single-Domain Stabilization on Si (100) - 2x1" (von P.Bedrossian et al. in Phys. Rev. Let., Vol. 68 (1992), No. 5, pp. 646-649) und in der Veröffentlichung **VI** "STM measurements of step-flow kinetics during atom removal by low-energy-ion bombardement of Si(001) (von B.S: Swartzentruber et al. in Surface Science 329 (1995) 83-89) beschrieben.

Bislang wurde in der Fachwelt angenommen, dass die oben genannten Erkenntnisse zur Beeinflussung der Stufenstruktur einer rekonstruierten Si(100)-Oberfläche bei der Präparation im Ultrahochvakuum (UHV) auch auf Gasphasenprozesse (CVD, chemische Gasphasenabscheidung; MOVPE, metallorganische Gasphasenepitaxie) zur Präparation der Si-Oberfläche bei einem moderaten Prozessgasdruck übertragen werden können. Präparationsverfahren, die kein extremes Vakuum erfordern (im Gegensatz zur MBE, Molekularstrahlepitaxie im UHV), besitzen große Relevanz für industrielle Prozesse, da sie wesentlich einfacher umzusetzen und zu skalieren sind. Unabhängige Studien unter vergleichbaren Bedingungen (H₂ als Prozessgas, nahezu atmosphärischer Druck) sind jedoch selten und geben keinen Konsens wieder. Die ersten eigenen STM-Ergebnisse der Erfinder in der Veröffentlichung **VII** "Atomic structure of Si(100) substrates prepared in a chemical vapor environment" (von H. Döscher et al., in Applied Surface Science 257 (2010) 574-580) geben somit den Stand des Wissens weitgehend wieder. In den Veröffentlichungen **VIII** "Si(001) surface preparation for the antiphase domain free heteroepitaxial growth of GaP on Si substrate" (von B. Kunert et al. in Thin Solid Films 517 (2008) 140-143) und **IX** " Atomic Force Microscopy Observation of Si(1 00) Surface after Hydrogen Annealing" (von Y. Yanase et al., J. Electrochem. Soc. Vol. 141 (1994), No. 11, pp. 3259-3263) wurden ähnlich präparierte Oberflächen mit einer jedoch unzureichenden AFM-Auflösung untersucht und unterschiedliche Ergebnisse erhalten. In der Veröffentlichung **VIII** wird von einem Trend zu Doppelstufen auf nahezu exakt orientierten Oberflächen berichtet.

Aus Sicht einer Erklärung des Stufenausbildungsprozesses in Gasatmosphäre ist die starke Wechselwirkung der Si(100)-Oberfläche mit dem H₂-Prozessgas entscheidend. Hierüber wird von den Erfindern in den Veröffentlichungen **X** "Si(100) surfaces in a hydrogen-based process ambient" (von H. Döscher et al. in Appl. Phys. Lett. 97, 151905-1..3 (2010)), **XI** "In situ investigation of hydrogen interacting with Si(100)" (von S. Brückner et al. in Appl. Phys. Lett. 98, 211909-1..3 (2011)) und **XII** "Quantitative investigation of hydrogen bonds on Si(100) surfaces prepared by vapour phase epitaxy" (von A. Dobrich at al. in J.Vac.Sci. Technol. B29(4), 2011, 04D114-1..3) berichtet.

In der Gruppe der Schutzrechte beschäftigt sich die DE 100 06 108 A1 mit der Epitaxie von Aluminiumnitrid unter Wasserstoffatmosphäre, wobei eine Si(100)-Schicht oberhalb von 1100°C mit D_{B}-Doppelstufen präpariert wird, um anschließend die Aluminiumnitridschicht eindomänig aufwachsen zu lassen. Dabei wird die Substrattemperatur schrittweise bis zur Epitaxietemperatur des Aluminiumnitrids stufenweise erhöht. Weiterhin beschäftigt sich die DE 197 25 900 C2 mit der Epitaxie von Galliumnitrid auf einem Siliziumsubstrat in stickstoffreicher Atmosphäre, wobei zunächst eine Aluminiumarsenidschicht aufgebracht und diese in eine Aluminiumnitridschicht umgewandelt wird, auf der dann anschließend die Galliumnitridschicht aufgewachsen wird. Schließlich ist aus der US 6 589 856 B2 ein Verfahren zur Kontrolle der Antiphasendomänen bekannt, bei dem zunächst auf ein monokristallines Siliziumsubstrat ein monokristalliner Perovskitoxidfilm aufgebracht wird. Alle genannten Schutzrechte geben keinen Hinweis auf die gezielte Steuerbarkeit der Domänenausbildung in einem reinen Si-System.

Die Veröffentlichung **XII** bildet daher den zur Erfindung nächstliegenden Stand der Technik. Es wird das gattungsgemäße Verfahren offenbart, bei dem eine Si(100)-Schicht epitaktisch auf einem Siliziumsubstrat präpariert wird. Die Präparation erfolgt nicht im technisch aufwändig umzusetzenden extremen Vakuum, sondern bei einem moderaten Prozessdruck aus der Gasphase in einer Wasserstoffumgebung (Wasserstoffgas als Prozessgas). Das eingesetzte Siliziumsubstrat weist eine kontaminationsfreie Oberfläche auf, die wiederum eine bekannte Fehlorientierung aufweist. Die Ausbildung von bevorzugt Typ-A- oder Typ-B-Terrassen bzw. D_{A}- und D_{B}-Doppelstufen ist während der Oberflächenpräparation zumindest durch Verringerung der Prozesstemperatur beeinflussbar. Diesbezüglich führen die Verfasser der Druckschrift **XII** aus, dass sie in der Lage sind, eine bevorzugte Domänenbildung durch Veränderung des Kühlprozesses herbeizuführen. Den erreichten Domänenanteil können sie durch entsprechende Messungen quantifizieren. In-situ RAS-Messungen zeigen, dass die Si-H-Bindungen auf der Si(1 00)-Oberfläche bis zum Erreichen einer signifikanten Oberflächentemperatur oberhalb 700°C nicht stabil sind. Weiterhin wird berichtet, dass eine starke Interaktion mit dem molekularen Wasserstoff auch bei intermediären Prozesstemperaturen besteht. Es wird die Vermutung geäußert, dass die Variation der Oberflächenpräparation im Gasphasenepitaxie (VPE)-Prozess in Richtung einer geringeren Abkühlungsrate in Anwesenheit von Wasserstoff als Prozessgas die Möglichkeit eröffnet, Si(100)-Oberflächen mit starker Vorzugsdomänen erzeugen zu können. Schon die Variation der Abkühlungsrate bedingt unterschiedliche Domänenverteilungen auf der Oberfläche. Ein VPE-Prozess, der ausschließlich in der finalen Kühlsequenz modifiziert wird, führt zu einer starken Bevorzugung in der Domänenverteilung, dies konnte durch Messergebnisse nachgewiesen werden. Weitere, insbesondere auch quantitative Aussagen über Art und Weise der Modifizierung und über die Abhängigkeit der Domänenausbildung von der auftretenden Fehlorientierung des Si-Substrats, werden in der Veröffentlichung **XII** jedoch nicht gemacht.

### Aufgabenstellung

Die **Aufgabe** für die vorliegende Erfindung ist daher darin zu sehen, das gattungsgemäße Verfahren mit einem Prozessdruck so weiterzubilden, dass der Fachmann ohne Weiteres in der Lage ist, die Domänenausbildung bei der Oberflächenpräparation einer Si(100)-Schicht auf einem Si-Substrat mit bekannter Fehlorientierung gezielt mit wählbaren Anteilen von Typ-A- und B-Terrassen (bzw. D_{A}- und D_{B}-Doppelstufen), zuverlässig und reproduzierbar zu kontrollieren. Die **Lösung** für diese Aufgabe ist dem Hauptanspruch zu entnehmen. Vorteilhafte Modifikationen des erfindungsgemäßen Verfahrens werden in den Unteransprüchen aufgezeigt und im Nachfolgenden im Zusammenhang mit der Erfindung näher erläutert.

Das beanspruchte Verfahren ist erfindungsgemäß durch eine einstellbare Ausbildung von Typ-A- und Typ-B-Terrassen mit wählbaren Anteilen gekennzeichnet, wobei
- die Prozesstemperatur T mit einer Änderungsrate ≤ 0,2°C/s bei konstantem Prozessdruck P verringert wird
   - gemäß **Präparationsdiagramm A** bei einer mittleren Fehlorientierung der Oberfläche des Si(100)-Substrats zwischen 0,5° und 4° oder
   - gemäß **Präparationsdiagramm B** bei einer starken Fehlorientierung der Oberfläche des Si(100)-Substrats größer 4° oder wobei
- die Prozesstemperatur T mit einer Änderungsrate ≥ 2°C/s und der Prozessdruck P mit einer Änderungsrate ≤ 3 mbar/s verringert werden gemäß **Präparationsdiagramm C** bei einer geringen Fehlorientierung der Oberfläche des Si(100)-Substrats kleiner 0,5°.

Mit dem erfindungsgemäßen Verfahren werden dem Fachmann somit spezielle Präparationsdiagramme zur Verfügung gestellt, die er für die Parametrierung zur wählbaren Einstellung der Anteile von Typ-A- und Typ-B-Terrassen bei der Oberflächenrekonstruktion einer Si(100)-Schicht benötigt. Dadurch kann der Fachmann Parametergebiete bestimmen, in denen er bei der Oberflächenrekonstruktion nur Domänen mit Typ-A-Terrassen oder nur Domänen mit Typ-B-Terrassen oder eine Mischung davon erhält. Bemerkenswert ist die Reversibilität der Ausbildung unterschiedlicher Domänenbereiche, d.h. der Fachmann kann anhand der Präparationsdiagramme durch entsprechende Parametrierung Domänen mit Typ-B-Terrassen in Domänen mit Typ-A-Terrassen auf der Si(100)-Oberfläche umstrukturieren und umgekehrt. Diese direkte und einfache reversible Abhängigkeit der Domänenausbildung, vor allem auch für die unüblichen D_{A}-Stufen, von den Prozessparametern Temperatur und Druck und vom Substratparameter Fehlorientierung führt zu dem mit der Erfindung nutzbaren Ergebnis, die Domänenausbildung bei der Oberflächenpräparation eines Si(1 00)- Substrates durch gezielte Anwendung von Prozessparametern und -zyklen kontrolliert steuern zu können. Dies erfolgt zudem in technisch einfach umzusetzenden Epitaxieverfahren ohne extreme Vakuumerzeugung. Mit dem erfindungsgemäßen Verfahren können Doppelstufen auf Si(100)-Oberflächen beispielsweise innerhalb einer CVD- bzw. MOVPE-Umgebung bei moderatem Prozessgasdruck bis in den Bereich des Atmosphärendruck für verschiedene Fehlorientierungen des Substrats, insbesondere auch für nahezu exakt orientiertes Material, reproduzierbar erzeugt werden. Auch der bislang als völlig unwahrscheinlich erachtete D_{A}-Stufentyp mit einer senkrechten Ausrichtung der Dimere zur Doppelstufenkante kann völlig gleichberechtigt zu einer Ausbildung des konventionellen D_{B}-Stufentyps gezielt erzeugt werden.

Nur das kontrollierte Abkühlen entscheidet in Abhängigkeit von der Fehlorientierung der der Substrat-Oberfläche über die sich bildende vorwiegende Stufenstruktur bzw. den vorwiegenden Terrassentyp. Dabei muss bei Substratoberflächen mit einer niedrigeren Fehlorientierung der kritische Temperatur-bereich möglichst schnell durchlaufen werden, damit es nicht zu einem Abtrag der Terrassen kommt. Bei Substratoberflächen mit mittlerer und hoher Fehlorientierung kann die jeweilige Vorzugsdomäne direkt im kritischen Temperaturbereich und je nach Prozessdruck eingestellt werden, hier kann also der kritische Temperaturbereich langsam durchlaufen werden. Allerdings kann zur Präparation von vornehmlich Typ-B-Terrassen auf Substraten mit hoher Fehlorientierung auch schnell abgekühlt werden. Wenn der für die Ausbildung von einer bestimmten Stufenstruktur entscheidende Temperaturbereich zu schnell durchlaufen wird, entsteht eine gemischte oder nur teilweise geordnete Stufenstruktur. Insbesondere das "schnelle Abkühlen" ist abhängig von den apparativen Gegebenheiten und durch die maximale Abkühlgeschwindigkeit des Reaktors begrenzt. Eine Temperaturänderung ≥ 2°C/s ist als schnell zu bezeichnen, wohingegen Temperaturänderungen mit ≤ 0,2°C/s als langsam zu bezeichnen sind. Dabei bezieht der Fachmann aber auch Rate in der Umgebung dieser genannten Raten jeweils in die Kategorie "schnelles Abkühlen" und "langsames Abkühlen" durchaus mit ein. Die Druckänderungsraten sind bei den Fällen mit mittlerer und hoher Fehlorientierung untergeordnet. Nach der Einstellung eines hohen oder niedrigen Drucks muss bei mittleren und hohen Fehlorientierungen lediglich gewartet werden, dass sich bei der gewählten Prozesstemperatur der gewünschte Terrassentyp bildet. Um den gewünschten Vorzugsterrassentyp zu präparieren, kann entweder unter den angegebenen Bedingungen direkt abgekühlt werden (ggfs. nach dem Standardpräparationsprozess zur Erreichung einer kontaminationsfreien Substratoberfläche vor Präparationsbeginn s.u.) oder zunächst noch einmal auf eine Temperatur oberhalb der relevanten Temperatur hochgeheizt werden, um die bestehende Domänenverteilung aufzulösen und anschließend beim Abkühlen die gewünschte Vorzugsdomäne / Vorzugsterrassentyp zu erhalten. Der gewünschte Terrassentyp entsteht immer nur auf dem Abkühlweg, wobei insbesondere die Abkühlgeschwindigkeit je nach Fehlorientierung und gewünschter Stufenstruktur eine entscheidende Rolle spielt.

Es existieren mittlerweile Verfahren für eine in-situ-Kontrolle der sich bildenden Domänen bzw. der Domänengrenzen APD bzw. APB. Die beispielsweise in der DE 10 2009 051 765 B4 eingesetzte Messmethode basiert auf der "Reflexions-Anisotropie-Spektroskopie" (RAS), die in der Literatur teilweise auch als "Reflexions-Differenz-Spektroskopie" (RDS) bekannt ist. Das dort vorgestellte Verfahren ermöglicht eine optische in-situ Quantifizierung von APDs in polaren hetero-epitaktischen Schichten, die auf nicht-polare Substrate (Wafer) abgeschieden werden, sodass APDs entstehen. Es basiert auf der hohen Oberflächenempfindlichkeit der RAS hinsichtlich Oberflächenrekonstruktionsdomänen. Oberflächenareale, die von APDs bedeckt sind, führen per Definition des RAS-Signals zu einer Reduktion bis hin zu einer vollkommenen Auslöschung des Signals, was durch den Beitrag der verschieden orientierten Domänen mit entsprechend unterschiedlichem Vorzeichen zur Gesamtintensität bedingt ist. Daraus lässt sich durch die Kenntnis der Signalhöhe, die auf einer rekonstruierten, aber von APDs freien Oberfläche gemessen wurde, der APD-Gehalt gleichartiger kristalliner Materialien mit unbekanntem APD-Gehalt prinzipiell durch einfache Verhältnisrechnung bestimmen. Die RAS ist eine zerstörungsfreie optische Messmethode im Nichtvakuum zur Bestimmung anisotroper Eigenschaften von Oberflächen von Festkörpern. Als Spezialfall der spektroskopischen Ellipsometrie wird bei der RAS der Polarisationszustand des von einer Probe reflektierten Lichts, das linear polarisiert, orthogonal und mit nur geringer Leistung eingestrahlt wird, spektral ausgewertet. Anisotropien entstehen in diesem Fall bevorzugt an Oberflächen und Grenzflächen verschiedener Schichten, da dort die Symmetrie des Volumenkristalls reduziert ist. Das macht die RAS zu einer oberflächensensitiven Messmethode. Wird der Kristall um 90° gedreht, so wird das RAS-Signal hinsichtlich seines Vorzeichens invertiert. Es ergibt sich eine Differenz der Polarisationsrichtungen. Dabei werden das Auftreten und die Höhe des invertierten Messsignals als Anzeichen und als Maß für den auftretenden Anteil an APD genutzt. RAS kann somit zur in-situ-Kontrolle der Domänenbildung bei der Oberflächenrekonstruktion einer Si(100)- Schicht auf einem Si-Substrat gut eingesetzt werden.

Anhand der Kenntnis der charakteristischen RA-Spektren der Si(100)-Oberflächen und deren Abhängigkeit von den Parametern Fehlorientierung des Substrats, Temperatur, Wasserstoffbedeckung sowie Oberflächenrekonstruktion und Verhältnis der Dimerorientierung lassen sich gezielt einzelne geeignete Wellenlängen zur zeitabhängigen Prozessbeobachtung und -überwachung auswählen. Neben aufschlussreicher Messungen lassen sich so auch gezielt erheblich vereinfachte und auf ein breiteres Spektrum von Depositionsanlagen (speziell für die industrielle Fertigung) anwendbare Sensoren konstruieren, die auf Messung der RA-Intensität bei nur einer bzw. weniger Wellenlängen basieren und sich idealerweise mit einem einfach Laser betreiben lassen. Bevorzugt und vorteilhaft kann das erfindungsgemäße Verfahren daher dahingehend modifiziert werden, dass zunächst die vorhandene Domänenausbildung der präparierten Si(100)-Oberfläche mittels in-situ-Messung eines Reflexions-Anisotropie-Spektrums detektiert und mit dem Reflexions-Anisotropie-Spektrum einer Referenzprobe mit der gewählten Domänenausbildung verglichen wird und bei einer Abweichung eine Erhöhung der Prozesstemperatur T vor der Verringerung der Prozesstemperatur T durchgeführt wird, um anschließend die gewählte Domänenausbildung durch die Verringerung der Prozesstemperatur T zu erreichen, wobei die Prozesstemperatur T mit einer beliebigen Änderungsrate und bei konstantem Prozessdruck P erhöht wird
- gemäß **Präparationsdiagramm D** bei einer mittleren Fehlorientierung der Oberfläche des Siliziumsubstrats zwischen 0,5° und 4° oder
- gemäß **Präparationsdiagramm E** bei einer starken Fehlorientierung der Oberfläche des Siliziumsubstrats größer 4° oder
- gemäß **Präparationsdiagramm F** bei einer geringen Fehlorientierung der Oberfläche des Siliziumsubstrats kleiner 0,5°

Das Siliziumsubstrat wird also zunächst hochgeheizt und damit die vorhandene Domänenausbildung bei entsprechenden Temperaturen aufgelöst, um anschließend dann durch gesteuertes Abkühlen die gewünschte Domänenausbildung beim Abkühlprozess zu erhalten. Als weitere Prozessgrößen kann bevorzugt und vorteilhaft Wasserstoff H₂ als Prozessgas, das der Erzeugung der Wasserstoffumgebung dient, und Silan (SiₙH₂ₙ Stoffgruppe der Verbindungen aus Silizium als Grundgerüst mit Wasserstoff) als Precursorgas, das der Homoepitaxie der Si(100)-Schicht dient, eingesetzt werden. Dabei kann der Anteil von Silan im Wasserstoffgas beliebig eingestellt werden und beispielsweise zwischen 1 % und 10% liegen und beliebig weiter verdünnt werden.

Wichtige Voraussetzung für die zuverlässige Steuerung der Domänenausbildung nach der Erfindung ist eine kontaminationsfreie und glatte, d.h. insbesondere bei niedriger Fehlorientierung nicht welliger Substratoberfläche, zu deren Erzielung vor Beginn des Verfahrens nach der Erfindung in der Regel eine Standardpräparation durchgeführt wird. Dabei wird bevorzugt und vorteilhaft die Oberfläche des Siliziumsubstrats zumindest desoxidiert. Dieser Desoxidationsschritt ist als Vorbereitung für die gesamte Präparation zwingend nötig, da hier eine reine, unkontaminierte Siliziumoberfläche auf dem Substrat entsteht. Zur Desoxidation sind Temperaturen von mindestens 950°C und Annealingzeiten von 30 min notwendig, um alle Verunreinigungen zu entfernen. Es kann bei auch bei höheren Temperaturen ausgeheizt werden, wodurch sich die notwendige Dauer verkürzt. Grenze ist hier mehr oder weniger die Schmelztemperatur von Silizium. Der Druck spielt hierbei keine Rolle. Bevorzugt und vorteilhaft kann deshalb die Oberfläche des Siliziumsubstrats in Wasserstoff bei einer Prozesstemperatur T in einem Bereich oberhalb von 950°C und unterhalb der Schmelztemperatur des Siliziumsubstrats für eine Dauer von 30 min bei 950°C oder kürzer bei einer höheren Prozesstemperatur T desoxidiert werden. Zur weiteren Verbesserung der Substratoberfläche können optional und in Abhängigkeit vom Substrattyp (Offcut, Fehlorientierung des Oberflächenschnitts) noch eine Pufferschicht aufgewachsen und ein Annealingschritt durchgeführt werden. Vorteilhaft und bevorzugt kann deshalb nach dem Desoxidieren der Oberfläche des Siliziumsubstrats eine Silizium-Pufferschicht epitaktisch aufgewachsen werden. Ziel des Wachstums ist, Unebenheiten auszugleichen. Dafür ist eine Schichtdicke der Pufferschicht von zumindest 100 nm erforderlich. Hohe Schichtdicken >1µm sind zu vermeiden, da es zu einer Bildung von Defekten in den Schichten kommen kann. Bevorzugt und vorteilhaft ist es deshalb, wenn die Silizium-Pufferschicht mit einer Schichtdicke zwischen 100 nm und 1 µm auf dem Siliziumsubstrats unter Zuführung von gasförmigem Silan und gasförmigem Wasserstoff bei einer Prozesstemperatur T zwischen 800°C und 1000°C und einem Prozessdruck P von 200 mbar aufgewachsen wird. Durch ein ebenfalls optionales Annealing wird prinzipiell die Desoxidation fortgesetzt. Es kann beliebig lange und bei mindestens 950°C durchgeführt werden. Bevorzugt und vorteilhaft ist es deshalb, wenn die dekontaminierte Oberfläche des Siliziumsubstrats oder die aufgewachsene Silizium-Pufferschicht bei einer Prozesstemperatur T von 1000°C und einem Prozessdruck P von 950 mbar für eine Prozesszeit t von 10 min erhitzt wird. Durch das Wachstum einer Pufferschicht und das nachträgliche Annealing wird sichergestellt, dass Oberflächenunebenheiten ausgeglichen werden und eine gleichmäßige, homogene glatte Oberfläche erzeugt wird. Bei Substraten mit niedriger Fehlorientierung ist dieser Schritt oft erforderlich, da hier eine wellige Oberfläche größere Auswirkung auf die Stufenstruktur hat.

### Ausführungsbeispiele

Das Verfahren nach der Erfindung mit seinen möglichen Modifikationen wird nachfolgend anhand der Präparationsdiagramme und zugehörigen Messkurven und bildlichen Darstellungen zum weiteren Verständnis der Erfindung näher erläutert. Dabei zeigt:
- **Figur 1**: Prinzipdarstellung zur Nomenklatur (unten) und Legende zu den Präparationsdiagrammen (oben),
- **Figur 2**: Präparationsdiagramm **A** für langsames Abkühlen ≤ 0,2°C/s, mittlere Fehlorientierung des Substrats zwischen 0,5° und 4°
- **Figur 3**: Referenz-RAS-Signaldiagramm von Si(100)-2°-Substraten mit vorherrschend Typ-A- und Typ-B-Terrassen bei 50°C
- **Figur 4**: STM-Bild eines D_{A}-gestuften Si(100)-2°-Substrats,
- **Figur 5**: STM-Bild eines D_{B}-gestuften Si(100)-2°-Substrats,
- **Figur 6**: Präparationsdiagramm **D** für Heizen, mittlere Fehlorientierung des Substrats zwischen 0,5° und 4°,
- **Figur 7**: Präparationsdiagramm **B** für langsames Abkühlen ≤ 0,2°C/s, starke Fehlorientierung des Substrats größer 4°,
- **Figur 8**: Referenz-RAS-Signaldiagramm von Si(100)-6°-Substraten mit vorherrschend Typ-A- und Typ-B-Terrassen t bei 50°C
- **Figur 9**: STM-Bild eines teilweise D_{A}-gestuften Si(100)-6°-Substrats,
- **Figur 10**: STM-Bild eines D_{B}-gestuften Si(100)-6°-Substraten,
- **Figur 11**: Präparationsdiagramm **E** für Heizen, starke Fehlorientierung des Substrats > 4°,
- **Figur 12**: Präparationsdiagramm **C** für schnelles Abkühlen ≥ 2 °C/s, geringe Fehlorientierung der Oberfläche des Si-Substrats kleiner 0,5°
- **Figur 13**: transientes-RAS-Signal von Si(100)-0,1°-Substraten bei 770°C für oszillierende Ausprägung von Typ-A- und Typ-B-Terrassen durch Materialabtrag,
- **Figur 14**: STM-Bild eines D_{A}-gestuften Si(100)-0,1°-Substrats,
- **Figur 15**: STM-Bild eines ungeordneten Si(100)-0,1°-Substrats und
- **Figur 16**: Präparationsdiagramm **F** für Heizen, geringe Fehlorientierung des Substrats kleiner 0,5°.

Zur Probenpräparation wurden Si(100)-Substrate mit unterschiedlicher Fehlorientierung in [011]-Kristallrichtung verwendet. Die Substrate werden auf einem Probenträger befestigt und in einem MOVPE-Reaktor (metal-organic vapour phase epitaxy - metallorganische Gasphasenepitaxie) prozessiert. Die Siliziumsubstrate befinden sich in einer Prozessgasatmosphäre. Die Prozessgasatmosphäre dient zum Schutz der Probe vor Reaktion mit der Umgebung (z.B. Sauerstoff, Kohlenstoff) und zum Transport von Precursoren aus den Quellen (z.B.: Bubbler oder Gasgemische) in den Reaktorraum. Über einen Suszeptor werden die Substrate erhitzt. Die Precursoren sind so beschaffen, dass sie bei bestimmten Temperaturen an der Substratoberfläche zerfallen und sich dann die entsprechenden Elemente auf dem Substrat anlagern. Über Massenflussregler lassen sich die Konzentrationen der Precursoren in der Prozessgasatmosphäre einstellen. Bei der vorliegenden Erfindung werden Silane SiₙH₂₍ₙ₊₁₎ verwendet, die 1% und 10% anteilig in Wasserstoff H₂ verdünnt sind. Über das Verhältnis Prozessgas H₂ zu Silan kann die Konzentration im Reaktor eingestellt werden. Bei Standard-MOVPE-Reaktoren werden die Substrate direkt auf den Suszeptor gelegt und über ein mit Stickstoff betriebenes Schleusensystem in den Reaktor gebracht.

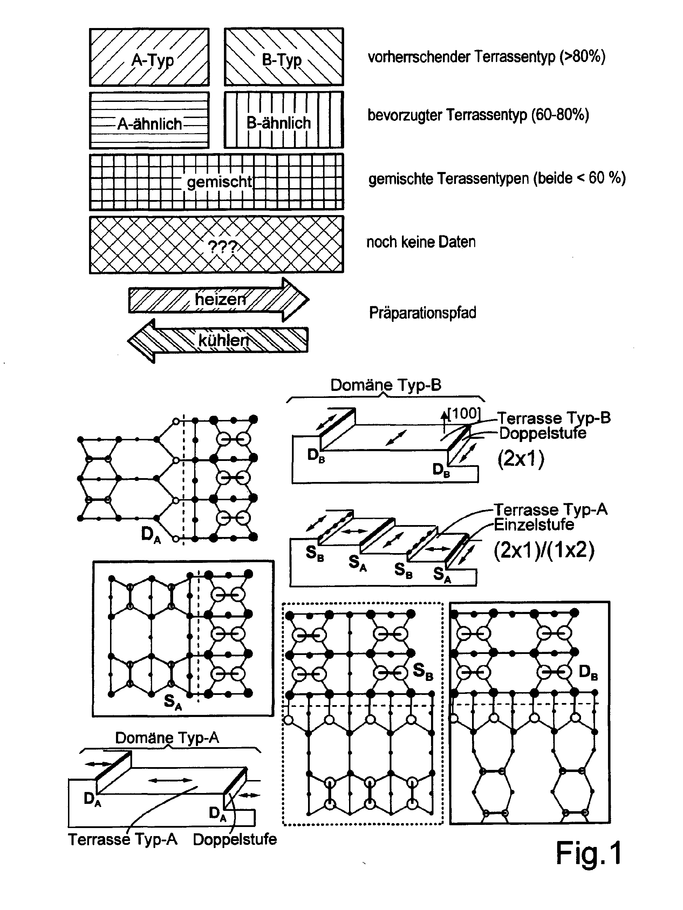

In der **Figur 1** ist im unteren Teil eine Übersicht zu den verschiedenen Strukturen aufgezeigt. Zu erkennen sind S_{A}- und S_{B}-Einzelstufen und D_{A}- und D_{B}-Doppelstufen mit der jeweiligen Ausrichtung der Dimere. Weiterhin ist dargestellt, dass sich die Terrassen zwischen den jeweiligen Stufen erstrecken. Eine Typ-A-Terrasse wird von D_{A}-Doppelstufen, eine Typ-B-Terrasse von D_{B}-Doppelstufen begrenzt. Bei Doppelstufen fügen sich mehrere Terrassen zu einer Domäne gleicher Orientierung der Dimere zusammen (Domäne Typ A oder Typ B).

Im oberen Teil der **Figur 1** ist die Legende zu den Präparationsdiagrammen aufgezeigt. In den Präparationsdiagrammen ist der Prozessdruck P in mbar über der Prozesstemperatur T in °C aufgezeigt. Es werden Domänen mit einem vorherrschenden Anteil von Typ-A oder Typ-B Terrassen > 80%, Domänen mit einem bevorzugten Anteil von Typ-A oder Typ-B Terrassen zwischen 60-80%), Domänen mit einem gemischten Anteil von (A-ähnlich, B-ähnlich (beide < 60%) sowie Gebiete aufgezeigt, über die bislang keine wissenschaftlichen Erkenntnisse vorliegen (???). Weiterhin wird der Präparationspfad (kühlen /heizen) zur gesteuerten Erzeugung einer gewünschten Domänenverteilung auf einer Si(100)-Oberfläche auf einem Si-Substrat nach der Erfindung aufgezeigt. Die Präparationsdiagramme basieren auf in-situ RAS-Messungen bzw. dem Benchmarking der RAS-Signale zu den entsprechenden UHV-Ergebnissen. Es werden drei Fälle unterschieden: ausgehend vom Standardfall einer mittlerer Fehlorientierung werden zudem die Grenzfälle sehr starker Fehlorientierung und sehr geringer Fehlorientierung beschrieben.

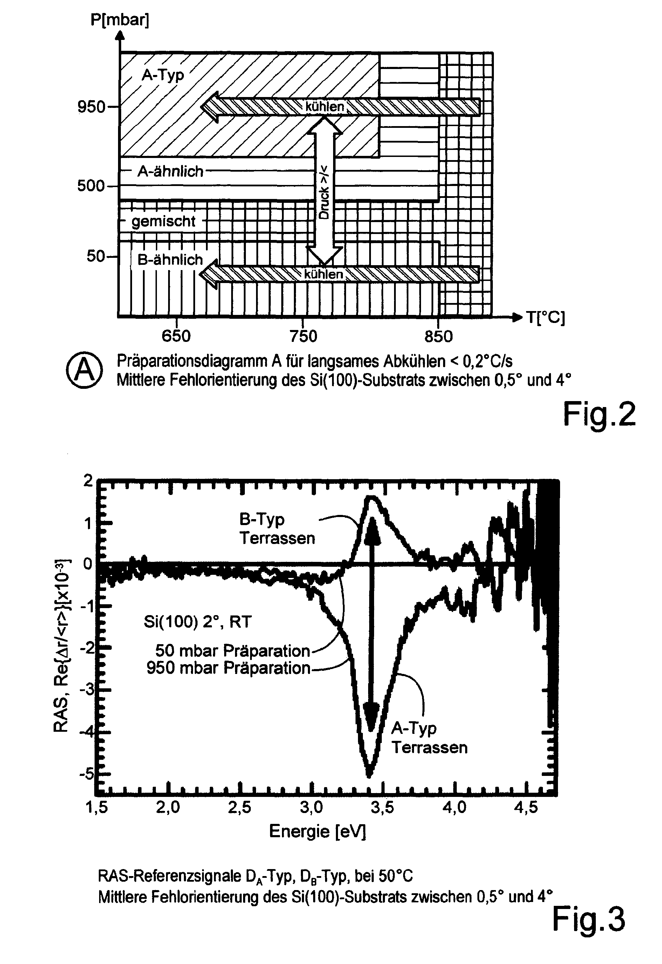

In **Figur 2** ist ein Präparationsdiagramm **A** für eine Fehlorientierung der Oberfläche des Si-Substrats zwischen 0,5° und 4° (Standardfall) für langsames Abkühlen ≤ 0,2 °C/s aufgezeigt. Das Präparationsdiagramm wird in der Form genutzt, dass zu einer gewählten Domänenverteilung die gemäß der in den Präparationsdiagrammen aufgezeigten Domänen zugehörigen Prozessparameter ausgewählt und eingestellt bzw. die zugehörigen Prozesszyklen durchfahren werden. So entstehen Terrassen mit vorherrschend Typ A (> 80 %) in einem Druck-Temperatur-Bereich mit den Eckpunkten 680 mbar/600 °C; 1260 mbar/600 °C; 1260 mbar/800 °C; 680 mbar/800 °C; Terrassen ähnlich Typ A (60 - 80 % Typ A) in einem Druck-Temperatur-Bereich mit den Eckpunkten 430 mbar/600 °C; 680 mbar/600 °C; 680 mbar/800 °C; 1260 mbar/800 °C; 1260 mbar/850 °C; 430 mbar/850 °C. Terrassen gemischten Typs (Typ A, Typ B, beide < 60%) werden in einem Druck-Temperatur-Bereich mit den Eckpunkten 160 mbar/600 °C; 430 mbar/600 °C; 430 mbar/850 °C; 1260 mbar/850 °C; 1260 mbar/900 °C; 0 mbar/900 °C; 0 mbar/850 °C; 160 mbar/850 °C ausgebildet bzw. ähnlich Typ B (60 - 80 % Typ B) in einem Druck-Temperatur-Bereich mit den Eckpunkten 0 mbar/600 °C; 160 mbar/600 °C; 160 mbar/850 °C; 0 mbar/850 °C.

Die **Figur 3** zeigt beispielhaft die RAS-Signale von Si(100)-2°-Substraten (monohydrid bedeckt), die vorzugsweise mit Typ-B- bzw. Typ-A-Terrassen bei 50°C präpariert wurden. Die Signale spiegeln sich an der X-Achse. Das Vorzeichen und die Größe des Peaks bei 3,4 eV hängen von der Ausprägung des vorherrschenden Terrassentyps ab. Zu erkennen ist, dass die Ausprägung in Richtung A-Typ stärker ist als in Richtung B-Typ.

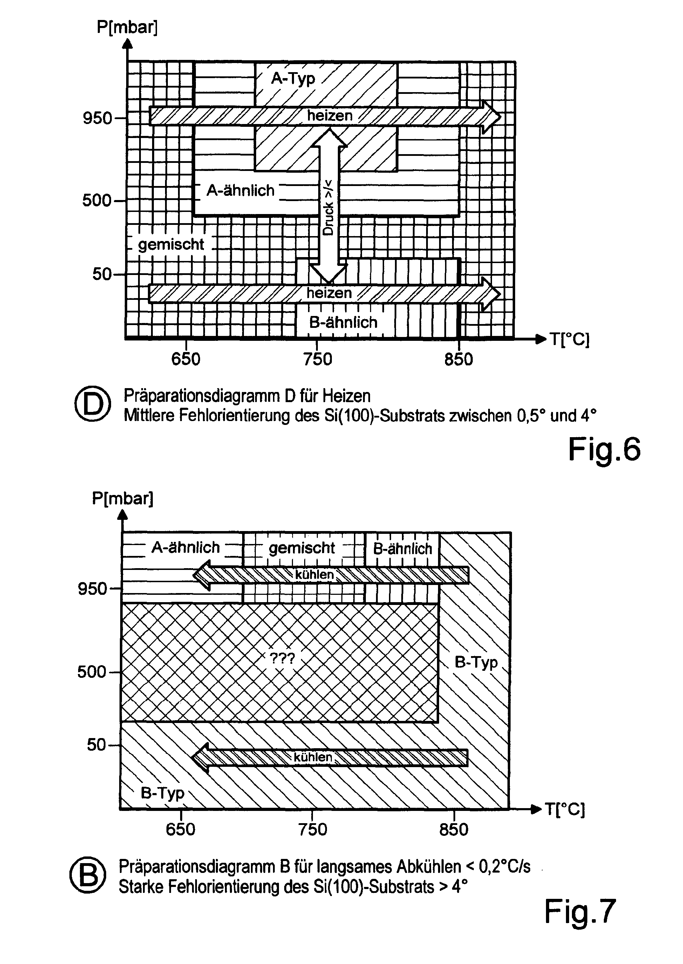

Als Ausführungsbeispiel wird für eine Erzeugung von D_{A}-Doppelstufen zur Erzeugung von Terrassen Typ A bei der Oberflächenrekonstruktion ein unkontaminiertes und glattes Si-2°-Substrat nach dem Standardprozess abgekühlt auf 400°C. Ein Vergleich der in-situ gewonnenen RAS-Signale beispielsweise mit den bei 50°C detektierten RAS-Signalen einer D_{A}-gestuften Referenzprobe gemäß **Figur 3** zeigt, dass die aktuelle Probe noch nicht perfekt präpariert wurde. Dann wird entsprechend dem Präparationsdiagramm **D** gemäß **Figur 6** das Substrat zunächst bei 950 mbar auf 720°C wieder erhitzt, sodass sich die Typ-A-Terrassen bzw. D_{A}-Doppelstufen ausbilden können. Die **Figur 6** zeigt die Terrassenbildung mit vorherrschend Typ A (> 80 %) in einem Druck-Temperatur-Bereich mit den Eckpunkten 650 mbar/700 °C; 1260 mbar/700 °C; 1260 mbar/805 °C; 650 mbar/805 °C; ähnlich Typ A (60 - 80 % Typ A) in einem Druck-Temperatur-Bereich mit den Eckpunkten 400 mbar/655 °C; 1260 mbar/655 °C; 1260 mbar/700 °C; 650 mbar/700 °C; 650 mbar/805 °C; 1260 mbar/805 °C; 1260 mbar/850 °C; 400 mbar/850 °C; ähnlich Typ B (60 - 80 % Typ B) in einem Druck-Temperatur-Bereich mit den Eckpunkten 0 mbar/735 °C; 150 mbar/735 °C; 150 mbar/850 °C; 0 mbar/850 °C und die Ausbildung von Terrassen gemischten Typs (Typ A, Typ B, beide < 60 %) in einem Druck-Temperatur-Bereich mit den Eckpunkten 0 mbar/600 °C; 1260 mbar/600 °C; 1260 mbar/655 °C; 400 mbar/655 °C; 400 mbar/850 °C; 1260 mbar/850 °C; 1260 mbar/900 °C; 0 mbar/900 °C; 0 mbar/850 °C; 150 mbar/850 °C; 150 mbar/735 °C; 0 mbar/735 °C.

Das Präparationsdiagramm **A** gemäß **Figur 2** zeigt dann, wie abgekühlt werden muss: unter hohem Druck (950 mbar), um diesen Zustand zu erhalten. Durch Konstanthalten des Drucks kann dabei die gewählte Domänenverteilung eingefroren werden. Eine Reduzierung des Drucks würde das Ausprägen des anderen Terrassen- oder Stufentyps bewirken

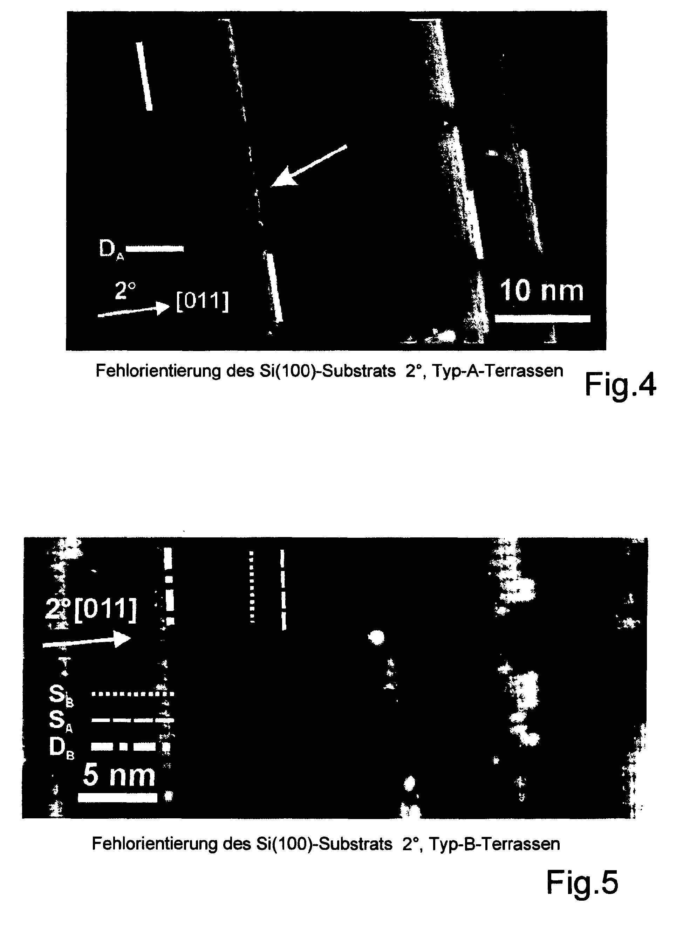

Die **Figur 4** zeigt das STM-Bild eines nach der vorbenannten Prozedur erzeugten D_{A}-gestuften Si(100)-2°-Substrats. Die Dimerreihen der Terrassen sind parallel zu den Stufenkanten ausgerichtet, d.h. die Oberfläche ist mit D_{A}-Doppelstufen gestuft. An den Stufenkanten sind teilweise noch Überreste von Einzelstufen zu erkennen (siehe Pfeil).

Alternativ können bevorzugt D_{B}-Doppelstufen auf einem Si(100)-2°-Substrat aufgewachsen werden. Nach dem Abkühlen auf 750°C wird der Prozessdruck auf 50 mbar geregelt und abgewartet, bis sich das aktuelle in-situ RAS-Signal ausgebildet hat. Dann wird bei 50mbar weiter abgekühlt, beispielsweise auf 400°C. Anschließend findet dann wieder ein RAS-Signalvergleich mit den Referenzsignalen einer D_{B}-gestuften Probe bei einer bestimmten Temperatur, beispielsweise 50°C, statt. Entsprechend dem Vergleich kann die Präparation dann abgeschlossen werden (Präparationsergebnis befriedigend) oder nochmals ein Aufheizen erfolgen, damit von der dadurch wieder aufgelösten, veränderten Oberflächenstrukturierung anschließend durch gezieltes, geführtes Abkühlen die gewünschte Oberflächenrekonstruktion erzielt werden kann. Die **Figur 5** zeigt das STM-Bild einer solchermaßen bevorzugt D_{B}-gestuften Si(100)-2°-Probe. An den Stufenkanten sind teilweise noch Überreste von Einzelstufen/ Zwischenterrassen zu erkennen.

In **Figur 7** ist das Präparationsdiagramm **B** für eine starke Fehlorientierung der Oberfläche des Si-Substrats > 4° für langsames Abkühlen ≤ 0,2 °C/s aufgezeigt. **Figur 7** zeigt auch die Druck-Temperatur-Bereiche, in denen die folgenden Terassenformen gebildet werden: ähnlich Typ A (60 - 80 % Typ A) in einem Druck-Temperatur-Bereich mit den Eckpunkten 880 mbar/600 °C; 1260 mbar/600 °C; 1260 mbar/690 °C; 880 mbar/690 °C; gemischten Typs (Typ A, Typ B, beide < 60 %) in einem Druck-Temperatur-Bereich mit den Eckpunkten 880 mbar/690 °C; 1260 mbar/690 °C; 1260 mbar/790 °C; 880 mbar/790 °C; ähnlich Typ B (60 - 80 % Typ B) in einem Druck-Temperatur-Bereich mit den Eckpunkten 880 mbar/790 °C; 1260 mbar/790 °C; 1260 mbar/835 °C; 880 mbar/835 °C; mit unbekannter Ausprägung in einem Druck-Temperatur-Bereich mit den Eckpunkten 200 mbar/600 °C; 880 mbar/600 °C; 880 mbar/835 °C; 200 mbar/835 °C und mit vorherrschend Typ B (> 80 %) in einem Druck-Temperatur-Bereich mit den Eckpunkten 0 mbar/600 °C; 200 mbar/600 °C; 200 mbar/835 °C; 1260 mbar/835 °C; 1260 mbar/900 °C; 0 mbar/900 °C.

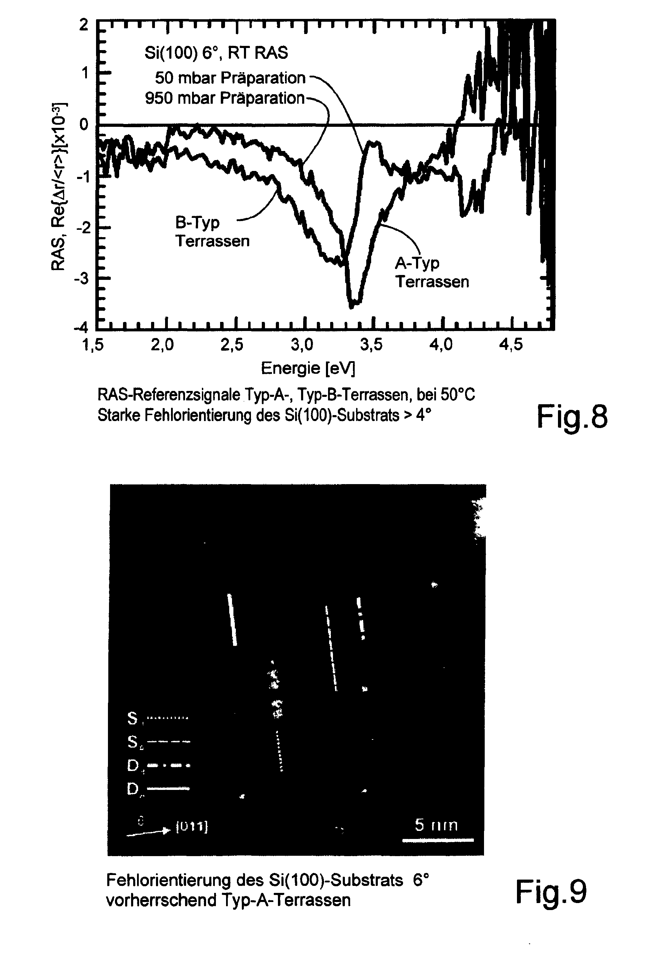

Die **Figur 8** zeigt die als Beispiele gewählten Referenz-RAS-Signale von Si(100)- 6°-Substraten (monohydrid bedeckt), die vorzugsweise mit Typ B-bzw. Typ A-Terrassen bei 50°C präpariert wurde. Das Signal von Substraten mit A-Typ-Terrassen entspricht dem Si(100)-2°-RAS-Signal gemäß **Figur 3****.** Das Signal von Substraten mit Typ B-Terrassen zeigt einen völlig anderen Verlauf. Die Ausprägung des B-Typs ist stärker.

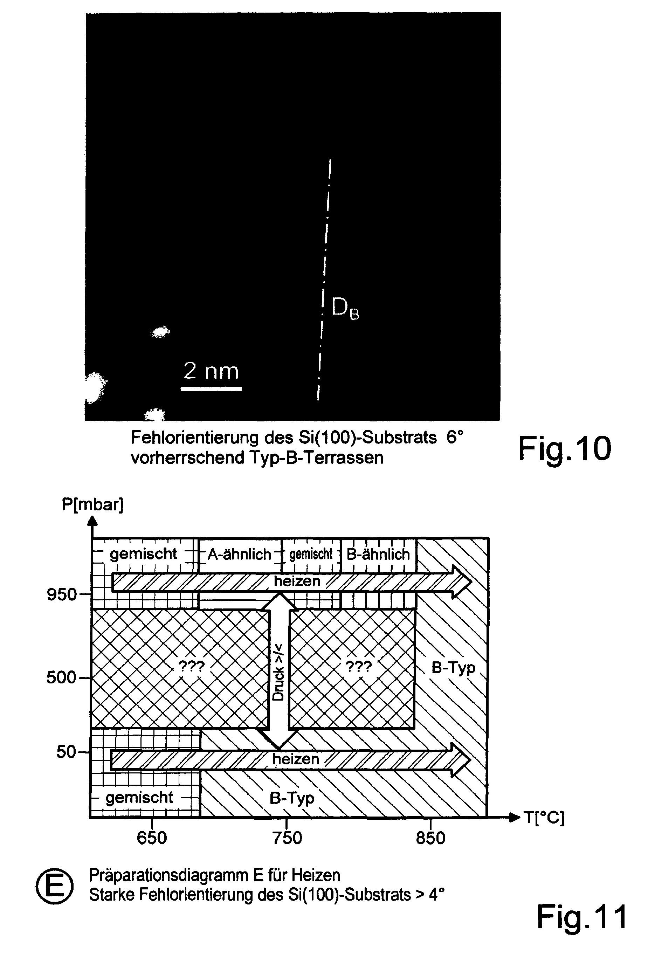

Für eine Präparation von D_{A}-Stufen auf einem Si-Substrat mit 6° Fehlorientierung erfolgt nach der Standardpräparation ein Abkühlen auf 720°C und das Warten auf die Ausbildung des RAS-Signals. Entsprechend dem Vergleichsergebnis mit dem Referenzsignal z.B. bei 50°C gemäß **Figur 8** erfolgt anschließend direkt bzw. nach einem erneuten Hochheizen entsprechend dem Präparationsdiagramm E gemäß **Figur 11** ein langsames Abkühlen von 700-770°C unter einem hohen H₂-Druck von 950 mbar bis zum Erreichen der gewünschten Oberflächenrekonstruktion mit D_{A}-Doppelstufen (Terrassen A-Typ). **Figur 11** zeigt die Druck-Temperatur-Bereiche, in denen bei einer starken Fehlorientierung der Oberfläche des Si(100)-Substrats größer 4° die folgenden Terrassentypen ausgebildet werden, wenn die Prozesstemperatur T bei konstantem Prozessdruck P mit einer beliebigen Änderungsrate erhöht wird. Terrassen gemischten Typs (Typ A, Typ B, beide < 60 %) enstehen in einem ersten Druck-Temperatur-Bereich mit den Eckpunkten 860 mbar/600 °C; 1260 mbar/600 °C; 1260 mbar/685 °C; 860 mbar/685 °C; in einem zweiten Druck-Temperatur-Bereich mit den Eckpunkten 860 mbar/745 °C; 1260 mbar/745 °C; 1260 mbar/790 °C; 860mbar/790°C und in einem dritten Druck-Temperatur-Bereich mit den Eckpunkten 0 mbar/600 °C; 200 mbar/600 °C; 200 mbar/685 °C; 0 mbar/685 °C. Terrassen ähnlich Typ A (60 -80 % Typ A) bilden sich in einem Druck-Temperatur-Bereich mit den Eckpunkten 860 mbar/685 °C; 1260 mbar/685 °C; 1260 mbar/745 °C; 860 mbar/745 °C; Terrassen ähnlich Typ-B (60 - 80 % Typ B) in einem Druck-Temperatur-Bereich mit den Eckpunkten 860 mbar/745 °C; 1260 mbar/745 °C; 1260 mbar/790 °C; 860 mbar/790 °C. Terrassen mit unbekannter Ausprägung werden in einem Druck-Temperatur-Bereich mit den Eckpunkten 200 mbar/600 °C; 860 mbar/600 °C; 860 mbar/840 °C; 200 mbar/840 °C und Terrassen mit vorherrschend Typ B (> 80 %) in einem Druck-Temperatur-Bereich mit den Eckpunkten 0 mbar/685 °C; 200 mbar/685 °C; 200 mbar/840 °C; 1260 mbar/840 °C; 1260 mbar/900 °C; 0 mbar/900 °C ausgebildet.

In der **Figur 9** ist das STM-Bild eines nach der vorbenannten Prozedur erzeugten D_{A}-gestuften Si(100)-6°-Substrats dargestellt. Die Dimerreihen sind stärker parallel zu den Stufenkanten ausgerichtet, es existieren aber auch Terrassen mit Dimerreihen senkrecht zu den Stufenkanten.

Zur Ausbildung von D_{B}-Doppelstufen bzw. Typ-B-Terrassen auf einem Substrat mit 6°-Fehlorientierung kann das Abkühlen bzw. Annealen entsprechend dem Präparationsdiagramm E gemäß **Figur 11** bei 700-1000°C unter niedrigem H₂-Druck (50mbar) erfolgen. Nach der Standardpräparation wird beispielsweise zunächst auf 750°C abgekühlt und der Druck auf 50mbar geregelt. Dann wird gewartet, bis sich das in-situ-Signal ausgebildet hat. Anschließend wird bei 50 mbar gezielt abgekühlt und das in-situ-RAS-Signal mit dem Referenzsignal bei 50°C gemäß **Figur 8** einer D_{B}-gestuften Probe verglichen. Je nach Vergleichsergebnis wird das Verfahren beendet oder direkt abgekühlt oder zunächst wieder hochgeheizt und anschließend abgekühlt, bis die gewünschte Domänenverteilung erreicht ist. In der **Figur 10** ist das STM-Bild einer solchermaßen hergestellten D_{B}-gestuften Si(100)-6°-Probe gezeigt.

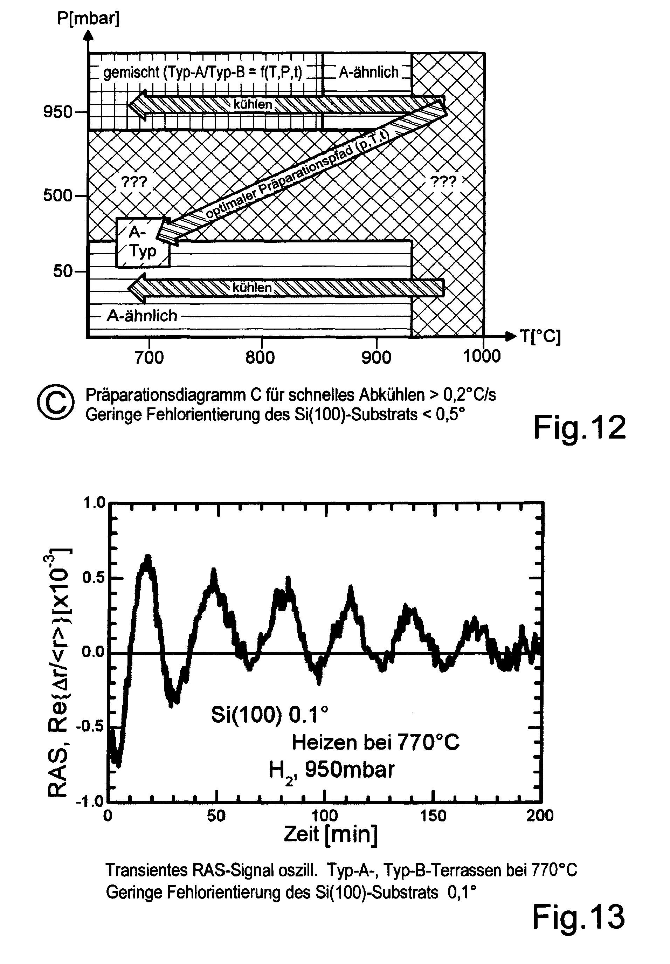

In **Figur 12** ist das Präparationsdiagramm **C** für eine geringe Fehlorientierung der Oberfläche des Si-Substrats < 0,5° für schnelles Abkühlen > 2 °C/s aufgezeigt. Der optimale Präparationspfad ist neben Prozessdruck und Prozesstemperatur auch von der Abkühlgeschwindigkeit, d.h. von der Prozesszeit t, abhängig. Ein Abbau der Terrassen während eines langsamen Abkühlens wird so verhindert. **Figur 12** zeigt die Druck-Temperatur-Bereiche, in denen bei einer geringen Fehlorientierung der Oberfläche des Si(100)-Substrats die folgenden Terrassentypen gebildet werden: Terrassen gemischten Typs (Typ A, Typ B, beide < 60 %) in einem Druck-Temperatur-Bereich mit den Eckpunkten 850 mbar/650 °C; 1260 mbar/650 °C; 1260 mbar/850 °C; 850 mbar/850 °C; Terrassen ähnlich Typ A (60 - 80 % Typ A) in einem Druck-Temperatur-Bereich mit den Eckpunkten 850 mbar/850 °C; 1260 mbar/850 °C; 1260 mbar/930 °C; 850 mbar/930 °C; Terrassen mit vorherrschend Typ A (>80 %) in einem Druck-Temperatur-Bereich mit den Eckpunkten 80 mbar/670 °C; 370 mbar/670 °C; 370 mbar/720 °C; 80 mbar/720 °C und Terrassen ähnlich Typ A (60 - 80 % Typ A) in einem Druck-Temperatur-Bereich mit den Eckpunkten 0 mbar/650 °C; 240 mbar/650 °C; 240 mbar/670 °C; 80 mbar/670 °C; 850 mbar/720 °C; 240 mbar/720 °C; 240 mbar/930 °C; 0 mbar/930 °C sowie mit unbekannter Ausprägung in einem Druck-Temperatur-Bereich mit den Eckpunkten 240 mbar/650 °C; 850 mbar/650 °C; 850 mbar/930 °C; 1260 mbar/930 °C; 1260 mbar/1000 °C; 0 mbar/1000 °C; 0 mbar/930 °C; 240 mbar/930 °C; 240 mbar/720 °C; 370 mbar/720 °C; 370 mbar/670 °C; 240 mbar/670 °C.

Die **Figur 13** zeigt die in-situ Transiente bei 3,2 eV gemessen an Si(100) 0,1 ° während des Heizens bei 770°C. Das Oszillieren entspricht der Entwicklung des B-Typ- bzw. A-Typ-Terrassensignals durch Abtrag der Terrassen aufgrund des Annealings bei 770°C und 950 mbar- vergleiche RAS-Signal gemäß **Figur 3****.**

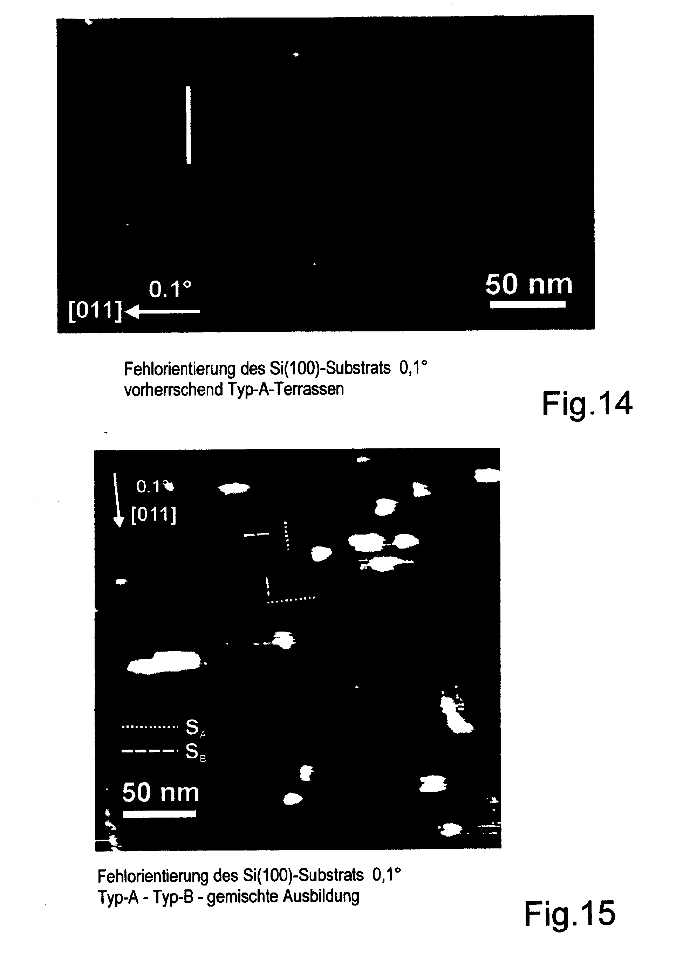

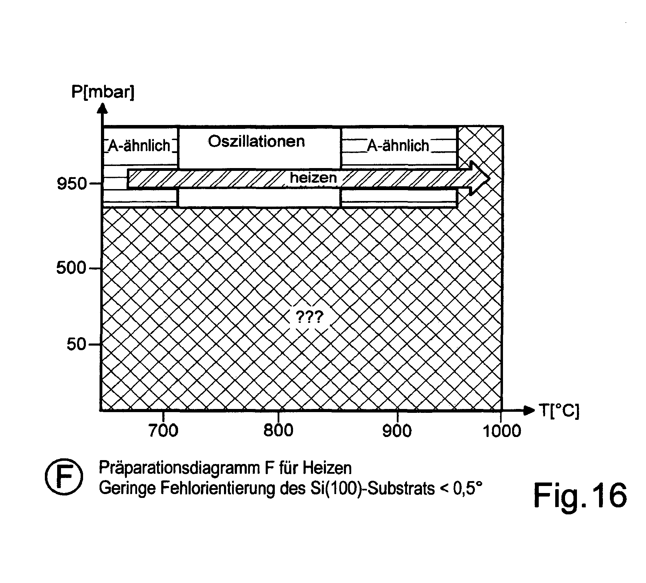

Beispielsweise können nach der Standardpräparation eines Si-Substrats mit einer Fehlorientierung von 0,1 ° für eine Präparation von D_{A}-Doppelstufen eine Änderung des Drucks von 950 auf 100 mbar während eines schnellen Abkühlen mit einer Geschwindigkeit ≥ 2°C/s über einen Zeitraum von 5 min durchgeführt werden. Es erfolgt dann ein Vergleich mit Referenzsignalen einer perfekt D_{A}-gestuften Probe bei einer bestimmten Temperatur (z.B. 400°C), vergleiche **Figur 3**. Es ergibt sich für eine bevorzugt D_{A} gestufte Si(100)-0,1°-Substratoberfläche ein STM-Bild gemäß **Figur 14****.** Je nach Ausgangsstrukturierung kann noch eine Erwärmung gemäß **Figur 16** vor dem eigentlichen schnellen Abkühlen vorgenommen werden. Dabei wird die Prozesstemperatur T bei konstantem Prozessdruck P mit einer beliebigen Änderungsrate erhöht. Bei einer geringen Fehlorientierung der Oberfläche des Si(100)-Substrats kleiner 0,5° entstehen dabei Terrassen ähnlich Typ A (60 - 80 % Typ A) in einem ersten Druck-Temperatur-Bereich mit den Eckpunkten 800 mbar/650 °C; 1260 mbar/650 °C; 1260 mbar/715 °C; 800 mbar/715 °C); in einem zweiten Druck-Temperatur-Bereich mit den Eckpunkten 800 mbar/850 °C; 1260 mbar/850 °C; 1260 mbar/955 °C; 800 mbar/955 °C und mit unbekannter Ausprägung in einem Druck-Temperatur-Bereich mit den Eckpunkten 0 mbar/650 °C; 800 mbar/650 °C; 800 mbar/955 °C; 1260 mbar/955 °C; 1260 mbar/1000 °C; 0 mbar/1000 °C. Diese Druck-Temperatur-Bereiche sind der **Figur 16** zu entnehmen.

Das STM-Bild eines bevorzugt D_{A}-gestuften Si(100)-0,1° Substrats ist in **Figur 15** gezeigt. Eine vorwiegende Präparation von D_{B}-Doppelstufen ist bei Si-Substraten mit einer Fehlorientierung kleiner 0,5° nicht ohne Weiteres, möglich. Im Temperaturbereich von 700-850°C werden Terrassen um Monolagen abgetragen, es entsteht eine "zerfledderte" Stufenstruktur. Eine gemischte Präparation aus Typ-A-Terrassen und Typ-B-Terrassen ist aber realisierbar und hängt neben dem Druck und der Temperatur auch von der Zeit t ab (Typ A /Typ B = f (T, P, t)).

## Patentansprüche

1. Verfahren, das der Oberflächenpräparation von kontaminationsfreien und glatten Si(100)-Substraten mit bekannter Fehlorientierung in Wasserstoffumgebung bei einem Prozessdruck dient, mit einer Beeinflussbarkeit der Ausbildung von Terrassen vom Typ A mit einem Vorzug für D_{A}-Doppelstufen mit senkrecht zu den Stufenkanten angeordneten Si-Dimeren oder Typ B mit einem Vorzug für D_{B}-Doppelstufen mit parallel zu den Stufenkanten angeordneten Si-Dimeren während der Oberflächenpräparation der wasserstoffterminierten Si(100)-Oberfläche zumindest durch Verringerung der Prozesstemperatur T,
**dadurch gekennzeichnet, dass**
die Ausbildung von Typ-A- oder Typ-B-Terrassen mit wählbaren Anteilen einstellbar ist, wobei
• die Prozesstemperatur T mit einer Änderungsrate ≤ 0,2°C/s bei konstantem Prozessdruck P verringert wird
• gemäß **Präparationsdiagramm A** (Figur 2) bei einer mittleren Fehlorientierung der Oberfläche des Si(100)-Substrats zwischen 0,5° und 4° oder
• gemäß **Präparationsdiagramm B** (Figur 7) bei einer starken Fehlorientierung der Oberfläche des Si(100)-Substrats größer 4° oder wobei
• die Prozesstemperatur T mit einer Änderungsrate ≥ 2°C/s und der Prozessdruck P mit einer Änderungsrate ≤ 3 mbar/s verringert werden gemäß **Präparationsdiagramm C** (Figur 12) bei einer geringen Fehlorientierung der Oberfläche des Si(100)-Substrats kleiner 0,5°.

2. Verfahren nach Anspruch 1,
**dadurch gekennzeichnet, dass**
bei einer mittleren Fehlorientierung der Oberfläche des Si(100)-Substrats zwischen 0,5° und 4° die Prozesstemperatur T bei konstantem Prozessdruck P zur Ausbildung von Terrassen
• mit vorherrschend Typ A (> 80 %) in einem Druck-Temperatur-Bereich mit den Eckpunkten 680 mbar/600 °C; 1260 mbar/600 °C; 1260 mbar/800 °C; 680 mbar/800 °C;
• ähnlich Typ A (60 - 80 % Typ A) in einem Druck-Temperatur-Bereich mit den Eckpunkten 430 mbar/600 °C; 680 mbar/600 °C; 680 mbar/800 °C; 1260 mbar/800 °C; 1260 mbar/850 °C; 430 mbar/850 °C;
• gemischten Typs (Typ A, Typ B, beide < 60%) in einem Druck-Temperatur-Bereich mit den Eckpunkten 160 mbar/600 °C; 430 mbar/600 °C; 430 mbar/850 °C; 1260 mbar/850 °C; 1260 mbar/900 °C; 0 mbar/900 °C; 0 mbar/850 °C; 160 mbar/850 °C;
• ähnlich Typ B (60 - 80 % Typ B) in einem Druck-Temperatur-Bereich mit den Eckpunkten 0 mbar/600 °C; 160 mbar/600 °C; 160 mbar/850 °C; 0 mbar/850 °C verringert wird;
oder
bei einer starken Fehlorientierung der Oberfläche des Si(100)-Substrats größer 4° die Prozesstemperatur T bei konstantem Prozessdruck P zur Ausbildung von Terrassen
• ähnlich Typ A (60 - 80 % Typ A) in einem Druck-Temperatur-Bereich mit den Eckpunkten 880 mbar/600 °C; 1260 mbar/600 °C; 1260 mbar/690 °C; 880 mbar/690 °C;
• gemischten Typs (Typ A, Typ B, beide < 60 %) in einem Druck-Temperatur-Bereich mit den Eckpunkten 880 mbar/690 °C; 1260 mbar/690 °C; 1260 mbar/790 °C; 880 mbar/790 °C;
• ähnlich Typ B (60 - 80 % Typ B) in einem Druck-Temperatur-Bereich mit den Eckpunkten 880 mbar/790 °C; 1260 mbar/790 °C; 1260 mbar/835 °C; 880 mbar/835 °C;
• mit unbekannter Ausprägung in einem Druck-Temperatur-Bereich mit den Eckpunkten 200 mbar/600 °C; 880 mbar/600 °C; 880 mbar/835 °C; 200 mbar/835 °C;
• mit vorherrschend Typ B (> 80 %) in einem Druck-Temperatur-Bereich mit den Eckpunkten 0 mbar/600 °C; 200 mbar/600 °C; 200 mbar/835 °C; 1260 mbar/835 °C; 1260 mbar/900 °C; 0 mbar/900 °C verringert wird;
oder
bei einer geringen Fehlorientierung der Oberfläche des Si(100)-Substrats kleiner 0,5° die Prozesstemperatur T mit einer Änderungsrate ≥ 2°C/s und der Prozessdruck P mit einer Änderungsrate ≤ 3 mbar/s zur Ausbildung von Terrassen
• gemischten Typs (Typ A, Typ B, beide < 60 %) in einem Druck-Temperatur-Bereich mit den Eckpunkten 850 mbar/650 °C; 1260 mbar/650 °C; 1260 mbar/850 °C; 850 mbar/850 °C;
• ähnlich Typ A (60 - 80 % Typ A) in einem Druck-Temperatur-Bereich mit den Eckpunkten 850 mbar/850 °C; 1260 mbar/850 °C; 1260 mbar/930 °C; 850 mbar/930 °C;
• mit vorherrschend Typ A (>80 %) in einem Druck-Temperatur-Bereich mit den Eckpunkten 80 mbar/670 °C; 370 mbar/670 °C; 370 mbar/720 °C; 80 mbar/720 °C;
• ähnlich Typ A (60 - 80 % Typ A) in einem Druck-Temperatur-Bereich mit den Eckpunkten 0 mbar/650 °C; 240 mbar/650 °C; 240 mbar/670 °C; 80 mbar/670 °C; 850 mbar/720 °C; 240 mbar/720 °C; 240 mbar/930 °C; 0 mbar/930 °C;
• mit unbekannter Ausprägung in einem Druck-Temperatur-Bereich mit den Eckpunkten 240 mbar/650 °C; 850 mbar/650 °C; 850 mbar/930 °C; 1260 mbar/930 °C; 1260 mbar/1000 °C; 0 mbar/1000 °C; 0 mbar/930 °C; 240 mbar/930 °C; 240 mbar/720 °C; 370 mbar/720 °C; 370 mbar/670 °C; 240 mbar/670 °C verringert werden.

3. Verfahren nach Anspruch 1,
**dadurch gekennzeichnet, dass**
zunächst die vorhandene Domänenausbildung der präparierten Si(100)-Oberfläche mittels in-situ-Messung eines Reflexions-Anisotropie-Spektrums detektiert und mit dem Reflexions-Anisotropie-Spektrum einer Referenzprobe mit der gewählten Domänenausbildung verglichen wird und bei einer Abweichung eine Erhöhung der Prozesstemperatur T vor der Verringerung der Prozesstemperatur T durchgeführt wird, um anschließend die gewählte Domänenausbildung durch die Verringerung der Prozesstemperatur T zu erreichen, wobei die Prozesstemperatur T mit einer beliebigen Änderungsrate und bei konstantem Prozessdruck P erhöht wird
• gemäß **Präparationsdiagramm D** (Figur 6) bei einer mittleren Fehlorientierung der Oberfläche des Si(100)-Substrats zwischen 0,5° und 4° oder
• gemäß **Präparationsdiagramm E** (Figur 11) bei einer starken Fehlorientierung der Oberfläche des Si(100)-Substrats größer 4° oder
• gemäß **Präparationsdiagramm F** (Figur 16) bei einer geringen Fehlorientierung der Oberfläche des Si(100)-Substrats kleiner 0,5°.

4. Verfahren nach Anspruch 3,
**dadurch gekennzeichnet, dass**
die Prozesstemperatur T mit einer beliebigen Änderungsrate und bei konstantem Prozessdruck P erhöht wird
bei einer mittleren Fehlorientierung der Oberfläche des Si(100)-Substrats zwischen 0,5° und 4° zur Ausbildung von Terrassen
• mit vorherrschend Typ A (> 80 %) in einem Druck-Temperatur-Bereich mit den Eckpunkten 650 mbar/700 °C; 1260 mbar/700 °C; 1260 mbar/805 °C; 650 mbar/805 °C;
• ähnlich Typ A (60 - 80 % Typ A) in einem Druck-Temperatur-Bereich mit den Eckpunkten 400 mbar/655 °C; 1260 mbar/655 °C; 1260 mbar/700 °C; 650 mbar/700 °C; 650 mbar/805 °C; 1260 mbar/805 °C; 1260 mbar/850 °C; 400 mbar/850 °C;
• ähnlich Typ B (60 - 80 % Typ B) in einem Druck-Temperatur-Bereich mit den Eckpunkten 0 mbar/735 °C; 150 mbar/735 °C; 150 mbar/850 °C; 0 mbar/850 °C;
• gemischten Typs (Typ A, Typ B, beide < 60 %) in einem Druck-Temperatur-Bereich mit den Eckpunkten 0 mbar/600 °C; 1260 mbar/600 °C; 1260 mbar/655 °C; 400 mbar/655 °C; 400 mbar/850 °C; 1260 mbar/850 °C; 1260 mbar/900 °C; 0 mbar/900 °C; 0 mbar/850 °C; 150 mbar/850 °C; 150 mbar/735 °C; 0 mbar/735 °C;
oder
bei einer starken Fehlorientierung der Oberfläche des Si(100)-Substrats größer 4° zur Ausbildung von Terrassen
• gemischten Typs (Typ A, Typ B, beide < 60 %) in einem ersten Druck-Temperatur-Bereich mit den Eckpunkten 860 mbar/600 °C; 1260 mbar/600 °C; 1260 mbar/685 °C; 860 mbar/685 °C; in einem zweiten Druck-Temperatur-Bereich mit den Eckpunkten 860 mbar/745 °C; 1260 mbar/745 °C; 1260 mbar/790 °C; 860mbar/790°C; in einem dritten Druck-Temperatur-Bereich mit den Eckpunkten 0 mbar/600 °C; 200 mbar/600 °C; 200 mbar/685 °C; 0 mbar/685 °C;
• ähnlich Typ A (60 -80 % Typ A) in einem Druck-Temperatur-Bereich mit den Eckpunkten 860 mbar/685 °C; 1260 mbar/685 °C; 1260 mbar/745 °C; 860 mbar/745 °C;
• ähnlich Typ-B (60 - 80 % Typ B) in einem Druck-Temperatur-Bereich mit den Eckpunkten 860 mbar/745 °C; 1260 mbar/745 °C; 1260 mbar/790 °C; 860 mbar/790 °C;
• mit unbekannter Ausprägung in einem Druck-Temperatur-Bereich mit den Eckpunkten 200 mbar/600 °C; 860 mbar/600 °C; 860 mbar/840 °C; 200 mbar/840 °C;
• mit vorherrschend Typ B (> 80 %) in einem Druck-Temperatur-Bereich mit den Eckpunkten 0 mbar/685 °C; 200 mbar/685 °C; 200 mbar/840 °C; 1260 mbar/840 °C; 1260 mbar/900 °C; 0 mbar/900 °C;
oder
bei einer geringen Fehlorientierung der Oberfläche des Si(100)-Substrats kleiner 0,5° zur Ausbildung von Terrassen
• ähnlich Typ A (60 - 80 % Typ A) in einem ersten Druck-Temperatur-Bereich mit den Eckpunkten 800 mbar/650 °C; 1260 mbar/650 °C; 1260 mbar/715 °C; 800 mbar/715 °C); in einem zweiten Druck-Temperatur-Bereich mit den Eckpunkten 800 mbar/850 °C; 1260 mbar/850 °C; 1260 mbar/955 °C; 800 mbar/955 °C;
• mit unbekannter Ausprägung in einem Druck-Temperatur-Bereich mit den Eckpunkten 0 mbar/650 °C; 800 mbar/650 °C; 800 mbar/955 °C; 1260 mbar/955 °C; 1260 mbar/1000 °C; 0 mbar/1000 °C.

5. Verfahren nach einem oder mehreren der vorangehenden Ansprüche,
**dadurch gekennzeichnet, dass**
Wasserstoff H₂ als Prozessgas, das der Erzeugung der Wasserstoffumgebung dient, und Silan als Precursorgas, das der Homoepitaxie der Si(1 00)-Schicht auf dem Si(100)-Substrat dient, eingesetzt wird.
